Europäisches Patentamt

European Patent Office

Office européen des brevets

(11) Numéro de publication: **0 398 778**
**A1**

## (12) DEMANDE DE BREVET EUROPEEN

(21) Numéro de dépôt: 90401184.8

(22) Date de dépôt: 02.05.90

(51) Int. Cl.5: **G11C 27/02**

(30) Priorité: 03.05.89 FR 8905871

(43) Date de publication de la demande:
**22.11.90 Bulletin 90/47**

(84) Etats contractants désignés:
**DE FR GB NL**

(71) Demandeur: **THOMSON COMPOSANTS MICROONDES**
**51, Esplanade du Général de Gaulle**
**F-92800 Puteaux(FR)**

(72) Inventeur: **Guiberteau, Christian**

THOMSON-CSF SCPI Cédex 67
F-92045 Paris la Défense(FR)
Inventeur: **Le Paih, Michèle**
THOMSON-CSF SCPI Cédex 67
F-92045 Paris la Défense(FR)
Inventeur: **Ruggeri, Stéphane**
THOMSON-CSF SCPI Cédex 67
F-92045 Paris la Défense(FR)

(74) Mandataire: **Taboureau, James et al**
**THOMSON-CSF SCPI**
**F-92045 Paris La Défense Cédex 67(FR)**

(54) Echantillonneur-bloqueur à haute fréquence d'échantillonnage.

(57) L'invention concerne un échantilloneur-bloqueur plus spécialement destiné à travailler dans les hyperfréquences (>1 GHz).

En vue d'augmenter la fréquence d'échantillonnage, le circuit selon l'invention comprend au moins deux voies parallèles identiques. Chaque voie comporte un premier interrupteur de suivi (9), une capacité (11) et un second interrupteur de maintien (15). Les voies sont commandées par une unique horloge dont les signaux (H, $\overline{H}$), complémentaires ou déphasés, adressent séquentiellement les échantillons vers la sortie (S).

Application au traitement de signaux analogiques.

FIG_3

La présente invention concerne une structure d'échantillonneur-bloqueur, réalisable soit sous forme de circuit intégré sur silicium ou matériaux III-V comme GaAs, soit sous forme de circuit hybride. La particularité de cet échantillonneur-bloqueur réside en ce qu'il délivre au moins deux fois plus d'échantillons qu'un échantillonneur-bloqueur classique, même si la fréquence d'échantillonnage est égale à la fréquence d'horloge du signal à échantillonner.

On sait que les échantillonneurs-bloqueurs, qui sont couramment désignés par leur abréviation E-B, sont utilisés dans le traitement d'informations électriques. Par exemple pour la numérisation d'un signal analogique : l'E-B échantillonne un certain nombre de valeurs momentanées de ce signal analogique, et ces valeurs, adressées à un convertisseur analogique-numérique, sont transformées en un nombre binaire.

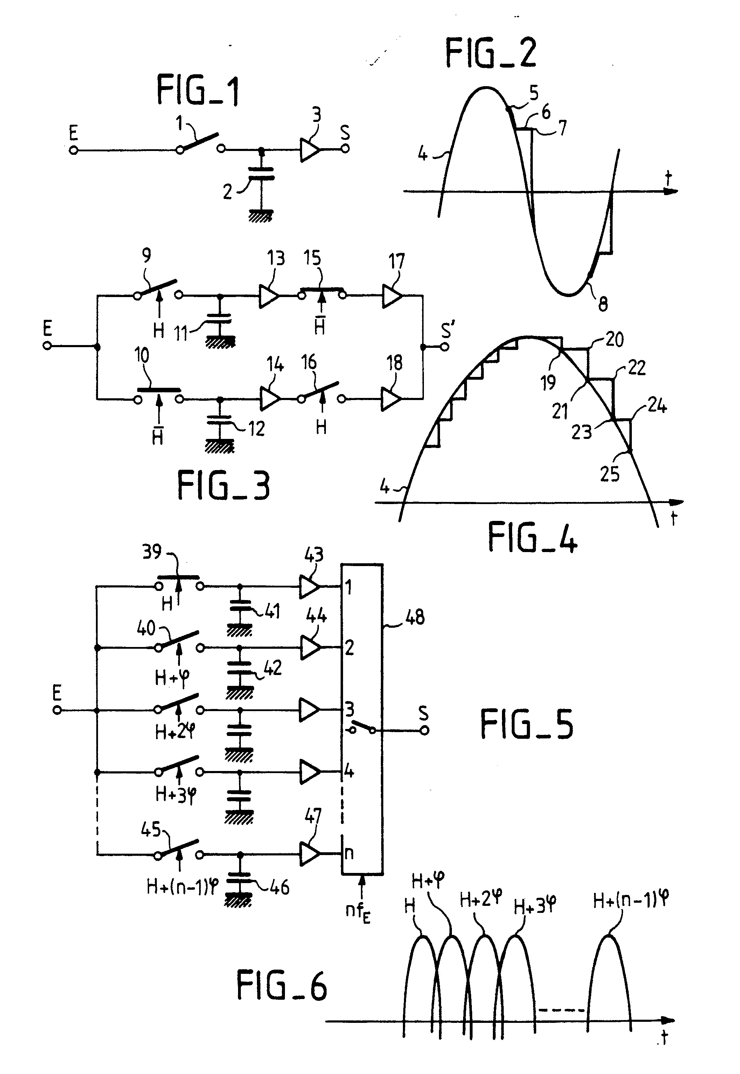

Il existe différentes structures d'E-B, utilisant soit un transistor, soit un pont de diodes, mais leur organisation commune est schématisée en figure 1. Un interrupteur 1 transmet - lorsqu'il est fermé- le signal analogique, présent à l'entrée E, à une capacité 2. L'équilibre s'établit et la capacité 2 se charge. L'interrupteur 1 est alors ouvert, et la capacité 2 transmet l'information mémorisée, souvent à travers un amplificateur 3, dans un circuit relié à la sortie S, souvent un convertisseur analogique numérique. Puis un nouvel échantillon est prélevé en refermant l'interrupteur 1.

C'est ce que représente la figure 2, sur laquelle une période d'un signal analogique 4 est échantillonnée au point 5 : tant que l'interrupteur 1 est fermé, entre les points 5 et 6, l'échantillonneur suit la variation du signal. Pendant le temps représenté par le segment 6-7, l'interrupteur est ouvert, et la capacilté 2 transmet la valeur échantillonnée. En 7, l'interrupteur est à nouveau fermé, l'échantillonneur rattrape puis suit le signal 4 jusqu'au prochain échantillon.

Les échantillonneur-bloqueurs actuellement disponibles sur le marché présentent un temps d'acquisition (<500 pS) permettant d'obtenir des fréquences du signal d'entrée allant jusqu'à 1 GHz. Ce temps d'acquisition est dépendant de la capacité de mémorisation.

Ainsi, dans un échantillonneur-bloqueur, le signal de sortie se décompose en une suite de phases de rattrapage, de suivi, de maintien du signal d'entrée. Dans toutes ces phases, les seules réellement intéressantes sont celles de maintien qui correspondent à l'information contenue auparavant dans le signal d'entrée. Les autres phases, bien qu'inhérentes au système, ne contiennent pas d'information utile. Afin de pouvoir reconstituer le signal d'entrée, il faut que le signal d'échantillonnage soit de fréquence au moins deux fois supérieure à celle du signal d'entrée. Ceci nécessite donc deux prises d'échantillons durant une période du signal d'entrée, pour respecter le théorème de Nyquist ou de Shannon : en figure 2, le signal 4 doit être échantillonné par exemple en 5 et 8, pendant une période.

Aux hyperfréquences, il devient délicat d'augmenter la fréquence d'échantillonnage en raison de l'incertitude sur le moment d'ouverture ou de fermeture de l'interrupteur 1, qui reste un dispositif semiconducteur, ayant donc un temps de basculement.

L'architecture de l'E-B selon l'invention permet de doubler au moins le nombre d'échantillons fournis pendant une période du signal d'entrée, sans modification de la fréquence d'échantillonnage. Ou, ce qui revient au même, de doubler la fréquence du signal d'entrée, sans dégradation des performances de linéarité.

Ce résultat est obtenu au moyen d'une structure d'E-B dans laquelle au moins deux voies d'échantillonnage travaillent en parallèle. Ces voies sont commandées soit par les deux signaux complémentaires H et $\overline{H}$ d'une même horloge, s'il n'y a que deux voies, soit par les signaux déphasés d'une même horloge s'il y a plus de deux voies. Mais quel que soit le nombre de voies en parallèle, seules sont transmises en sortie les phases de maintien. Par conséquent, une première voie peut suivre le signal, pendant qu'une seconde voie transmet en sortie et qu'une troisième voie rattrape le signal.

De façon plus précise, l'invention concerne un échantillonneur-bloqueur à haute fréquence d'échantillonnage, du type comportant une capacité, un premier interrupteur destiné à charger un échantillon du signal d'entrée dans la capacité pendant une phase dite de suivi du signal d'entrée et un deuxième interrupteur destiné à transférer l'échantillon vers la sortie pendant une phase dite de maintien , cet échantillonneur-bloqueur étant caractérisé en ce qu'il comporte au moins deux voies parallèles identiques, commandées par une unique horloge d'échantillonnage, chaque voie transmettant vers la sortie de façon séquentielle, pendant sa phase de maintien, l'échantillon chargé dans la capacité de ladite voie.

L'invention sera mieux comprise par la description plus détaillée de deux exemples de réalisation, en relation avec les figures jointes en annexe, qui représentent :

- figures 1 et 2 : rappel du fonctionnement d'un échantillonneur-bloqueur selon l'art connu, exposé précédemment,

- figure 3 : structure d'un E-B selon l'invention,

- figure 4 : courbe, en fonction du temps, d'une demi-période d'un signal à analyser, montrant le fonctionnement de l'E-B selon l'invention,

- figure 5 : structure d'une variante de l'E-B selon l'invention,

- figure 6 : diagramme dans le temps des signaux d'horloge de commande pour l'E-B de la figure précédente.

L'invention concerne davantage une architecture d'échantillonneur-bloqueur que les moyens précis mis en oeuvre pour réaliser cette architecture. C'est pourquoi, dans les figures 3 et 5, sont conservés les symboles d'un interrupteur qui peut être soit un transistor commandé par sa grille, soit un pont de diodes, en soi bien connus.

La figure 3 représente le schéma d'une variante préférée de l'E-B selon l'invention, en raison de sa simplicité qui assure ses performances en hyperfréquences. Entre une borne d'entrée E, sur laquelle est appliqué un signal analogique tel que 4 (fig.4), et une borne de sortie S, il comporte deux voies parallèles et identiques, sauf pour les signaux d'horloges.

La première voie comprend :
- un premier interrupteur 9 dit interrupteur de suivi, commandé par un signal d'horloge H,
- une capacité 11, chargée à travers le premier interrupteur lorsqu'il est fermé,
- un amplificateur 13,
- un second interrupteur 15, dit interrupteur de maintien, commandé par un signal d'horloge $\overline{H}$, complément de H,
- un amplificateur 17.

Le deuxième voie est identique, mais les troisième et quatrième interrupteurs 10 et 16 sont commandés par des signaux d'horloge compléments de ceux qui commandent les premier et second interrupteurs 9 et 15, c'est à dire $\overline{H}$(10) et H (16).

Les signaux H et $\overline{H}$ peuvent être permutés entre eux.

Les quatre amplificateurs, mieux connus sous le nom de buffers, ne sont pas indispensables, mais il est bien connu qu'on en dispose dans les circuits pour compenser les pertes d'insertion en ligne. En outre, ils permettent d'éviter les transferts de charges, et donc de décharger les capacités 11 et 12, ce qui fausserait les échantillons.

Le fondement de cet E-B est qu'une voie suit le signal d'entrée tandis que l'autre voie transmet en sortie l'échantillon prélevé pendant la période d'horloge précédente.

Ainsi, tel que représenté sur la figure 3,
- sur la première voie, à un certain temps, l'interrupteur 9 est ouvert (H) l'interrupteur 15 est fermé ( $\overline{H}$ ) et transmet en sortie S l'échantillon contenu dans la capacité 11,
- mais simultanément, et non plus après ce moment comme dans un E-B de l'art connu, sur la deuxième voie, l'interrupteur 10 est fermé ( $\overline{H}$ ) et il charge la capacité 12 à partir du signal présent sur l'entrée E, la sortie S étant isolée par l'interrupteur 16 (H) ouvert.

A la période d'horloge suivante, la deuxième voie délivrera un échantillon en sortie S, et la première voie rechargera la capacité 11.

On ne transmet donc en sortie que les phases de maintien, les phases de suivi étant isolées par les interrupteurs : tout se passe comme si la fréquence d'échantillonnage était double de ce qu'elle est en réalité.

Ceci ressort de la figure 4, sur laquelle une demi-période du signal d'entrée est échantillonnée un grand nombre de fois. Admettons qu'au point 19, la première voie transmette en sortie l'échantillon stocké : ce transfert dure le temps H d'une demi-période d'horloge jusqu'en 20. Mais pendant ce même temps, la deuxième voie suit le signal de 19 jusqu'en 21, et charge la capacité 12. Pendant une deuxième demi-période d'horloge, la deuxième voie transmet l'échantillon, depuis 21 jusque 22, et simultanément la première voie rattrape puis suit le signal de 21 jusque 23. Au cours d'une troisième demi-période d'horloge 23-24-25, le système a repris le même cycle qu'au cours de la première demi-période d'horloge 19-20-21.

Cette structure d'E-B à deux voies utilise une seule horloge d'échantillonnage qui fournit deux signaux H et $\overline{H}$ complémentaires. Il est possible de l'étendre à plus de deux voies, avec une seule horloge d'échantillonnage dont le signal est déphasé plusieurs fois.

La variante d'E-B représentée en figure 5 comprend "n" voies parallèles formées chacune, comme la première, d'un interrupteur 39, d'une capacité 41 et d'un buffer 43. Mais comme il n'est pas possible de se limiter à seulement deux signaux H et $\overline{H}$ pour "n" voies, les interrupteurs 39,40...45 sont commandés par un signal d'horloge H pour la première voie, déphasé d'une valeur $\phi$ pour la deuxième voie, d'une valeur $2\phi$ pour la troisième voie..., d'une valeur $(n-1)\phi$ pour la "n" ième voie, comme représenté sur la figure 6.

A partir d'un signal d'horloge, il est facile d'obtenir des signaux déphasés de $\phi$, $2\phi$, $3\phi$ ... $n\phi$, soit au moyen d'un circuit déphaseur à plusieurs étages, soit au moyen de lignes à retard montées en cascade.

La commande séquentielle des interrupteurs 39,40...45 permet de charger les capacités 41,42... 46 les unes après les autres, pour prélever un grand nombre d'échantillons du signal d'entrée, ou un nombre plus restreint d'échantillons mais sur un signal d'entrée à plus haute fréquence. C'est à dire que chaque voie respectant le théorème de Nyquist, l'ensemble des voies ne le respecte plus, et, avec une fréquence du signal d'échantillonnage $f_E$ égale à la fréquence du signal d'entrée, on peut disposer d'un grand nombre d'échantillons pour une période du signal d'entrée -tandis que selon l'art connu la fréquence d'échantillonnage doit être égale à au moins deux fois la fréquence d'entrée-.

Mais il est également possible - ce n'est qu'une question de déphasage- d'opérer avec un certain recouvrement partiel des périodes de suivi du signal et de charge des capacités. Dans ce cas, une voie commence à charger sa capacité avant que la voie précédente n'ait achevé de charger la sienne, ce qui permet d'augmenter encore le nombre d'échantillons.

Si, à l'entrée, un certain temps est nécessaire pour charger les capacités, en sortie par contre le transfert à un convertisseur analogique-numérique est quasi instantané. C'est pourquoi il est prévu un multiplexeur 48, qui interroge chaque voie l'une après l'autre, et transfère les échantillons contenus dans les capacités 41,42...46. Si $f_E$ est la fréquence d'échantillonnage appliquée sur les interrupteurs 39,40...45 des n voies, le multiplexeur est commandé par un signal d'horloge à fréquence $nf_E$, ce qui s'obtient facilement au moyen d'un multiplicateur de fréquence.

Il est évident pour l'homme de l'art que les moyens de commutation qui sont représentés sous le symbole d'un interrupteur sont, pour la réalisation en circuits intégrés sur silicium ou matériaux rapides tel que GaAs, en réalité des transistors à effet de champ ou bipolaires. En hyperfréquences, ces transistors ont leur source reliée à l'entrée E, leur drain relié à la capacité d'échantillonnage, et ils sont commandés sur leur grille par le signal d'horloge.

L'échantillonneur-bloqueur selon l'invention est utilisé de préférence en hyperfréquences, pour le traitement du signal en télécommunications, radars, faisceaux hertziens.

## Revendications

1 - Echantillonneur-bloqueur à haute fréquence d'échantillonnage, du type comportant une capacité (11), un premier interrupteur (9) destiné à charger un échantillon du signal d'entrée (E) dans la capacité (11) pendant une phase dite de suivi du signal d'entrée, et un deuxième interrupteur (15) destiné à transférer l'échantillon vers la sortie (S) pendant une phase dite de maintien, cet échantillonneur-bloqueur étant caractérisé en ce que le signal d'entrée (E) est appliqué simultanément sur au moins deux voies parallèles identiques (9,11,15) (10,12,16), commandées par les signaux déphasés d'une unique horloge d'échantillonnage, chaque voie transmettant vers la sortie de façon séquentielle, pendant sa phase de maintien, l'échantillon chargé dans la capacité (11,12) de ladite voie.

2 - Echantillonneur-bloqueur selon la revendication 1, caractérisé, en ce que, s'il ne comporte que deux voies parallèles (9,11,15) (10,12,16), l'unique horloge d'échantillonnage fournit les signaux d'horloge complémentaires H et $\overline{H}$, dont l'un (H) est appliqué sur l'interrupteur de suivi (9) d'une première voie et sur l'interrupteur de maintien (16) d'une deuxième voie, et dont son complément ($\overline{H}$) est appliqué sur l'interrupteur de maintien (15) d'une première voie et sur l'interrupteur de suivi (10) d'une deuxième voie.

3 - Echantillonneur-bloqueur selon la revendication 2, caractérisé en ce que des amplificateurs (13,14,17,18) sont intercalés, dans chaque voie derrière les interrupteurs (9,10,15,16), afin d'éviter les transferts de charges entre voie.

4 - Echantillonneur-bloqueur selon la revendication 1, caractérisé en ce qu'il comporte une pluralité de voies parallèles identiques, dont les seconds interrupteurs sont regroupés dans un unique multiplexeur (48), qui transmet vers la sortie (S), de façon séquentielle, l'échantillon chargé dans la capacité (41) d'une voie donnée, pendant sa phase de maintien.

5 - Echantillonneur-bloqueur selon la revendication 4, caractérisé en ce qu'une unique horloge d'échantillonnage commande les premiers interrupteurs (39) au moyen de signaux déphasés (H, H + $\phi$, H + 2$\phi$..., H + (n-1)$\phi$), et le multiplexeur (48) au moyen d'un signal dont la fréquence est un multiple ($nf_E$) de la fréquence d'échantillonnage ($f_E$) sur les voies, le coefficient de multiplication (n) étant égal au nombre (n) de voies parallèles.

6 - Echantillonneur-bloqueur selon la revendication 4, caractérisé en ce qu'il y a recouvrement partiel entre les périodes de suivi du signal d'entrée de deux voies adjacentes, une voie (40,42) commençant à charger sa capacité (42) avant que la voie précédente (39,41) n'ait achevé de charger la sienne (41).

7 - Echantillonneur-bloqueur selon l'une quelconque des revendications 1 ou 2, caractérisé en ce que les interrupteurs sont des transistors.

FIG_1

FIG_2

FIG_3

FIG_4

FIG_5

FIG_6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 260 375  (SEQUENCE INC.)<br>* Résumé; page 7, ligne 6 - page 8, ligne 5 * | 1 | G 11 C  27/02 |
| Y | US-A-3 701 152  (HOWARD)<br>* Résumé; colonne 2, ligne 51 - colonne 3, ligne 18 * | 1 | |
| A | DE-A-2 455 517  (YAMATAKE-HONEYWELL)<br>* Figures 1,3; page 2, ligne 1 - page 4, ligne 8; figure 4, page 4, lignes 23-37 * | 1 | |

| | DOMAINES TECHNIQUES RECHERCHES (Int. Cl.5) |
|---|---|
| | G 11 C  27/02 |

Le présent rapport a été établi pour toutes les revendications

| Lieu de la recherche | Date d'achèvement de la recherche | Examinateur |
|---|---|---|
| LA HAYE | 10-09-1990 | STECCHINA A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)